Europäisches Patentamt

European Patent Office

Office européen des brevets

(11) Publication number: **0 227 303**
**A2**

# (12) EUROPEAN PATENT APPLICATION

(21) Application number: **86309083.3**

(22) Date of filing: **20.11.86**

(51) Int. Cl.⁴: **H01L 21/00** , H01L 21/316

The title of the invention has been amended (Guidelines for Examination in the EPO, A-III, 7.3).

(30) Priority: **25.11.85 GB 8528967**

(43) Date of publication of application:
**01.07.87 Bulletin 87/27**

(84) Designated Contracting States:
**DE FR IT NL**

(71) Applicant: **PLESSEY OVERSEAS LIMITED**
**Vicarage Lane**
**Ilford Essex IGI 4AQ(GB)**

(72) Inventor: **Kenny, Peter Gerard**
**36 Sarrer Road**
**Kenton Harrow Middlesex(GB)**
Inventor: **Hunt, Peter Charles**
**17 Wordsworth Close**
**Towcester Northants(GB)**

(74) Representative: **Field, Howard John**
**THE PLESSEY COMPANY plc Vicarage Lane**
**Ilford Essex IG1 4AQ(GB)**

(54) **Method of manufacturing semiconductor devices having side-wall isolation.**

(57) A method (Figure 7) in which a silicon or poly-silicon feature (I) and overlayer of deposited dielectric (5) is protected by a covering layer (9) of nitride, a layer of polysilicon is deposited and is treated to define a sidewall fillet (I5) of oxide. It is preferred to carry out this last step by first etching back the polysilicon material (II) and then oxidising the remaining fillet (I3) to form this sidewall oxide (I5).

FIG. 7

## METHOD OF SEMICONDUCTOR DEVICE MANUFACTURE

Technical Field

The present invention concerns improvements in or relating to methods of semiconductor device manufacture, in particular methods for manufacturing devices having sidewall isolation.

Background Art

It is common practice in semiconductor manufacture to form dielectric sidewalls on polysilicon or silicon features by means of anisotropic etching of oxide.

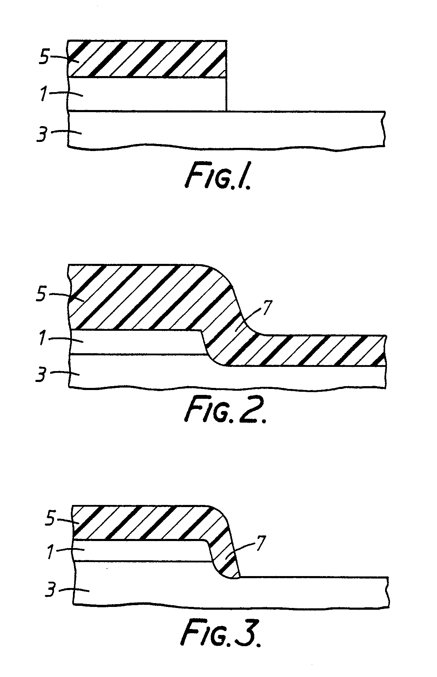

Figures I to 3 illustrate steps performed during a typical conventional sidewall isolation method. The starting point is a polysilicon/silicon feature I topped with oxide 5 which has been defined using anisotropic etching to achieve near-vertical walls, - (Fig.I). A sidewall oxide 7 is grown thermally - (Fig.2) then etched anisotropically (Fig.3).

This conventional method has several deleterious consequences. The polysilicon/silicon feature I and the substrate 3 are both oxidised away by an amount at least as thick as the resulting sidewall, and there is significant dopant redistribution in these regions. Note that deposited oxide could not ordinarily be used instead because of its poor quality and conformity. The anisotropic etch must remove a layer of oxide approximately twice as thick as the sidewall, any overetch causing damage to the underlying substrate. It is also usual that the overall step height is much greater than the final sidewall thickness achieved.

Disclosure of the Invention

The present invention provides an alternative method, a method intended to result in significantly less damage to the underlying substrate and to the polysilicon/silicon feature.

In accordance with the present invention there is provided a method of semiconductor device manufacture comprising the following steps:-
providing a silicon substrate and forming thereon a feature of either silicon or polysilicon material, this feature being topped by a layer of dielectric;
applying to this feature, and to the exposed surface of the silicon substrate, a covering layer of nitride;
applying to this covering layer, a layer of polysilicon material;

forming an oxide sidewall by a combination of thermal oxidation and anisotropic etching of the polysilicon material; and,
removing the exposed layer of nitride.

In the method aforesaid it is preferable to form the sidewall oxide by carrying out anisotropic etching prior to thermal oxidation. This preferred sequence has the advantage that the sidewall layer expands upon oxidation and thus forms a thicker structure than would be obtained by the reverse sequence.

The nitride covering layer serves to protect the polysilicon/silicon feature and the substrate during sidewall oxide growth and during the polysilicon anisotropic etch. It also acts as a barrier to interstitial defects generated at the advancing oxidation front and so inhibits enhanced diffusion effects. Thus the polysilicon/silicon feature and substrate are not oxidised during these steps. High pressure oxidation can be used to great advantage to minimise dopant redistribution during the sidewall oxidation. The sidewall oxide is of good quality because it is thermally grown.

Brief Introduction of the Drawings

In the drawings accompanying this specification:-
Figures I to 3 illustrate in cross-section, a substrate and feature at stages during the growth of a sidewall by a conventional method; and,

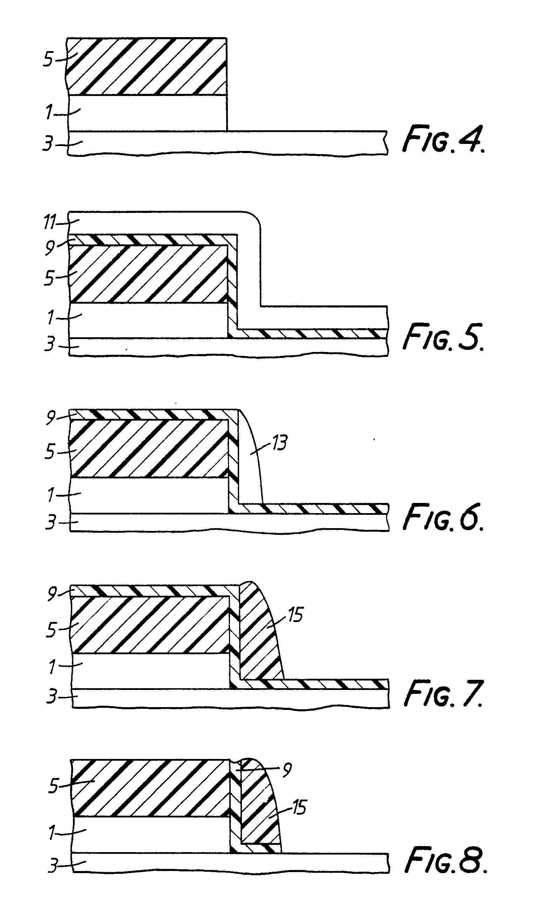

Figures 4 to 8 illustrate in cross-section, the same but where sidewall growth is performed by the method disclosed herein.

Description of Preferred Embodiments

So that the invention may be better understood, embodiments thereof will now be described with reference to the drawings. Such description as follows is given by way of example, only.

The successive steps performed for this inventive sidewall isolation technique are illustrated in Figures 4 .o 8. This technique has two novel features. The use of a protective nitride capping layer 9 and also use of an expanding polysilicon sidewall I3. As a result a composite nitride-oxide sidewall is produced consisting mainly of good quality thermal oxide I5. Figure 4 shows the same starting point as described for the conventional approach. Layers of silicon-nitride 9 and polysilicon II are deposited - (Fig.5). Prior to deposition of these layers, however, a thin pad oxide stress relief film may be grown if desired. The polysilicon layer II is etched anisotropically to leave a sidewall fillet I3 (Fig.6) which is then oxidised, (Fig.7). Alternatively the polysilicon may be oxidised first and this oxide etched anisotropically, but this does not have the advantage of the expansion of the polysilicon fillet as it oxidises. Finally the nitride 9 is etched off along with any pad oxide if present (Fig.8).

The method aforesaid may be used in advanced silicon bipolar processing. It is also possible that it will find application in MOS/CMOS processing.

## Claims

1. A method of semicondcutor device manufacture (figures 4-8) comprising the following steps:-
providing a silicon substrate (3) and forming thereon a feature (I) of either silicon or polysilicon material, this feature (I) being topped by a layer of dielectric (5);
applying to this feature (I), and to the exposed surface of the silicon substrate, a covering layer of nitride (9);
applying to this covering layer (9), a layer (II) of polysilicon material;
forming an oxide sidewall (I5) by a combination of thermal oxidation and anisotropic etching of the polysilicon material (II); and,
removing the exposed layer (9) of nitride.

2. A method, as claimed in claim I, wherein in the step of forming the sidewall oxide (I5), the polysilicon material (II) is etched prior to the thermal oxidation.

3. A method, as claimed in either claims I or 2, wherein the thermal oxidation is performed at a high pressure.

4. A method, as claimed in any one of the preceding claims, wherein a thin pad oxide layer is grown at the exposed surfaces of the feature (I) and substrate (3) prior to application of the covering layer of nitride (9).

5

1

3

*FIG.1.*

5

1

7

3

*FIG.2.*

5

1

7

3

*FIG.3.*

FIG.4.

FIG.5.

FIG.6.

FIG.7.

FIG.8.